# EUROPÄISCHE PATENTSCHRIFT

(11) **EP 2 051 936 B1**
(45) Veröffentlichungstag und Bekanntmachung des Hinweises auf die Patenterteilung: **21.05.2014**
(21) Anmeldenummer: 07817431.5
(22) Anmeldetag: 14.08.2007
(51) Int. Cl.: C01G 9/02, B82B 3/00, C01G 23/053, B82Y 30/00, C01G 1/02, C30B 7/00, C30B 29/16, C30B 29/60

(54) **VERFAHREN ZUR ERZEUGUNG VON OXIDISHEN NANOPARTIKELN AUS EINEM OXIDPARTIKEL BILDENDEN MATERIAL DURCH FILMSIEDEN**
METHOD FOR GENERATING OXIDIC NANOPARTICLES FROM A MATERIAL FORMING OXIDE PARTICLES
PROCÉDÉ PERMETTANT LA PRODUCTION DE NANOPARTICULES OXYDÉES À PARTIR D'UN MATÉRIAU QUI FORME DES PARTICULES D'OXYDE

(30) Priorität: 18.08.2006 DE 102006038703
(43) Veröffentlichungstag der Anmeldung: 29.04.2009
(73) Patentinhaber: Christian-Albrechts-Universität zu Kiel, 24118 Kiel (DE)
(72) Erfinder: ELBAHRI, Mady, 24104 Kiel (DE); ADELUNG, Rainer, 24116 Kiel (DE)
(74) Vertreter: Hansen, Jochen
(86) Internationale Anmeldenummer: PCT/DE2007/001444
(87) Internationale Veröffentlichungsnummer: WO 2008/019670

(56) Entgegenhaltungen:
- EP-A- 0 081 409
- WO-A-2007/076745
- DE-T5- 10 392 447
- B.J. URBAN, C.T. AVEDISIAN, W. TSANG: "The Film Boiling Reactor: A new enviroment for Chemical Processing" AICHE, Bd. 52, Nr. 7, 2006, Seiten 2582-2595, XP002492452 in der Anmeldung erwähnt
- D. WEN, Y. DING: "Experimental investigation into the pool boiling heat transfer of aqueous based gamma-alumina nanofluids" J. NANOPARTICLE RES., Bd. 7, 2005, Seiten 265-274, XP002492453

## Beschreibung

Die Erfindung betrifft die Erzeugung von oxidischen Nanopartikeln aus einem Oxid-partikel bildenden Material, insbesondere Metalloxid-Partikeln, und das Bilden eines Films solcher Partikel auf einem beliebigen Substrat.

Nanostrukturen, die selbst Nanopartikel sind oder durch gleichmäßige Verteilung und/oder regelmäßige Anordnung von Nanopartikeln auf einem Substrat gebildet werden, stehen zurzeit im Fokus aktueller Forschung. Sie repräsentieren eine Klasse von Materialen, die u. a. aufgrund von Quanteneffekten neuartige elektrische, optische, magnetische und thermodynamische Eigenschaften aufweisen. Neben den vorrangig akademischen Fragen stellt sich dabei auch das Problem der reproduzierbaren Massenfertigung mit möglichst einfachen Mitteln, um zeitnah den Bereich der gewerblichen Nutzung von Nanostrukturen zu erreichen.

Zum allgemeinen, die Herstellung von Nanostrukturen betreffenden Stand der Technik wird auf die folgenden Druckschriften verwiesen: D. Rovillain et al.: "Film boiling chemical vapor infiltration - An experimental study on carbon/carbon composite materials", Carbon 39, pp. 1355-1365 (2001); B.J. Urban und C.T. Avedisian, W. Tsang: "The Film Bioling Reactor: A New Environment for Chemical Processing", AlChE J. 52(7), pp. 2582-2595 (2006); WO 2007/076745 A bzw. DE 10 2005 060 407 B3; DE 103 92 447 T5; EP 0 81 409 A; Dongsheng Wen und Yulong Ding: "Experimental investigation into the pool boiling heat transfer of aqueous based γ-alumina nanofluids", Journal of Nanoparticle Research 7, pp. 265-274 (2005) und S.M. You, J.H. Kim, K.H. Kim: "Effect of nanoparticles on critical heat flux of water in pool boiling heat transfer", Appl. Phys. Lett. 83(16), pp. 2274-2276 (2003).

Insbesondere ist die Erzeugung eines gleichmäßig verteilten Films aus Nanopartikel auf der Oberfläche eines Substrats ist bis heute ein schwieriger Prozess, der üblich mit mehreren Schritten und hohen Kosten verbunden ist, insbesondere wenn die Nanopartikel überdies in bestimmter Weise angeordnet werden sollen. Typische Verfahren für die Herstellung solcher Strukturen sind Vapour Liquid Solid (VLS) oder MOCV Verfahren. Zwar sind diese Verfahren relativ universell anwendbar, aber sowohl die Kontrolle der Atmosphäre (UHV) als auch die Notwendigkeit hoher Temperaturen (600-1000°C) verlangen teures Equipment und machen die Synthese zeitaufwendig. Vorstrukturierte Substrate wie z.B. MEMS können solch hohen Temperaturen nicht ohne weiteres ausgesetzt werden.

Zur Reduktion des Aufwandes kennt der Fachmann ebenfalls nasschemische Herstellungsverfahren aus wässriger Lösung, die bei Temperaturen unter 100 C° und bei Atmosphärendruck zu den gewünschten Ergebnissen führen (z.B. siehe Law et al., "Nanowire dye-sensitized solar cells", nature materials, 4, 455-459, 2005). Allerdings haben die nasschemischen Methoden neben ihrem sehr langsamen Ablauf (Prozesszeiten von mehreren Stunden bis Tagen) andere Nachteile. So ist etwa kein epitaktisches Wachstum auf Silizium möglich (siehe J. Phys. Chem. B 2001, 105, 3350-3352). Außerdem kommen in manchen Fällen auch Lösungsmittel zum Einsatz, die ein Entsorgungsproblem mit sich bringen.

Beispielsweise ist man heute sehr an der Herstellung von Zinkoxid (ZnO) Nanostrukturen, etwa Nanostäbchen und Nanoröhren, interessiert. Dies ist schon deshalb der Fall, weil ZnO als Halbleiter eine große Variation an Nanostrukturen bilden kann. Überdies werden vielseitige Anwendungen als optoelektronische Bauteile, Laser, Feldemissions- und Gassensor-Materialien erwogen (zur Herstellung und Anwendung von Nanoröhren und Nanostäbchen siehe auch Advanced Materials 2005, 17, 2477). Um nun ZnO-Strukturen epitaktisch zu erzeugen werden entweder spezielle Substrate wie Galliumnitrid (GaN) benutzt oder Silizium-Substrate mit einem so genannten "Seeding Layer" beschichtet, der meistens aus einem bei 400 C° erhitzten ZnO Dünnfilm besteht.

Eine direkte, nicht eptitaktische Herstellung flächig verteilter ZnO-Strukturen auf Substraten geht aus der Patentanmeldung DE 10 2005 060 407 A1 hervor. Dabei werden Metallsalze, insbesondere Zinkacetat, in Wasser gelöst und auf ein zuvor erhitztes Substrat (z.B. Heizplatte) getropft. Die Tropfen verdampfen, wobei sie auf dem Dampfpolster schweben (Leidenfrost-Effekt), und auf der benetzten Substratfläche verbleiben verteilte Nanostrukturen, insbesondere etwa kleine Büschel aus ZnO-Drähten.

Der Leidenfrost-Effekt erscheint wesentlich für die Bildung der Nanopartikel aus den zuvor in Wasser gelösten Metallionen. Hierfür wird eine sehr schnell ablaufende Reaktionskinetik im Nichtgleichgewicht an der Phasengrenze Fluid/Wasserdampf an der Unterseite des Tropfens als Ursache angenommen. Die genaue Natur der Prozesse dort ist bislang nicht geklärt.

Neben weiteren Vorteilen z.B. hinsichtlich der gerichteten Anordnung von Nanodrähten hat das in der DE 10 2005 060 407 A1 beschriebene Verfahren allerdings den Nachteil, dass es nicht ohne weiteres zur Beschichtung beliebiger Substrate geeignet ist. Offensichtlich treten Probleme bei gekrümmten, lokal vertieften oder erst recht abgewinkelten Substratoberflächen auf, wenn die verdampfenden Tropfen darüber gleiten sollen. Überdies muss das Substrat Temperaturen oberhalb von 200 °C für längere Zeit standhalten - wobei es auch nicht oxidieren soll, was die Materialauswahl u. a. im Bereich der Kunststoffe einschränkt.

Es ist jedoch in einer kürzlich erschienenen Arbeit (Urban and Avedisian, "The Film Boiling Reactor: A New Environment for Chemical Processing", AIChE Journal, 52, 7, S. 2582-2595 (2006)) darauf hingewiesen worden, dass der Prozess des Filmsiedens ("film boiling"), der dem Leidenfrost-Effekt ähnelt, effektive chemische Umsetzungen ermöglicht. Konkret wird dort ein so genannter FIBOR ("film boiling reactor") zur Erzeugung von Wasserstoffgas aus Methanol beschrieben.

Es ist daher die Aufgabe der Erfindung, ein Verfahren zur schnellen Erzeugung von Nanopartikeln anzugeben, das zugleich ein sehr einfaches Aufbringen von Filmen solcher Partikel auf weitgehend beliebige Substrate erlaubt.

Die Aufgabe wird gelöst durch ein Verfahren mit den Merkmalen des Hauptanspruchs. Die Unteransprüche geben vorteilhafte Ausgestaltungen des Verfahrens an.

Erfindungsgemäß ist die Erzeugung der Nanopartikel durch chemische Umsetzung von in Wasser gelösten Ionen, insbesondere Metallionen, an der Phasengrenze Wasser/Wasserdampf zwischen dem Wasserkörper und einer dem Wasserkörper Wärme zuführenden Fläche (z.B. Heizplatte) vorgesehen. Insofern wird das Konzept der Partikelerzeugung aus der DE 10 2005 060 407 A1 übernommen. Die Realisierung dieser Konfiguration erfolgt jedoch hier nicht durch Auftropfen der Lösung, sondern durch Filmsieden in einem ggf. kontinuierlich arbeitenden Reaktor. Das Acronym FIBOR wird im Folgenden für diesen Reaktor übernommen.

Die Erfindung sieht ferner vor, dass wenigstens die Oberseite des Wasserkörpers frei zugänglich ist. Es zeigt sich nämlich, dass die erfindungsgemäß gebildeten Nanopartikel nach ihrer Bildung, die vorzugsweise an der Unterseite des Wasserkörpers stattfindet, Auftrieb erfahren und schließlich in großer Zahl auf der Wasseroberfläche schwimmen. Beim Eintauchen eines weitgehend beliebigen Substrates in den Wasserkörper von der mit schwimmenden Partikeln versehenen Oberfläche her binden diese sofort an das Substrat, so dass das Substrat nach dem Herausziehen mit einem relativ fest haftenden Nanopartikelfilm überzogen ist.

Die Erfindung wird nachfolgend näher erläutert. Dazu dienen auch die folgenden Abbildungen:
- Fig. 1: skizziert das unterschiedliche Siedeverhalten von Wasser für verschiedene Werte der Temperaturdifferenz ΔT = T_{Wand} - T_{Wasser} zwischen einer Wärmeenergie abgebenden, mit dem Wasser kontaktierten Wand und dem Wasserkörper selbst;
- Fig. 2: zeigt die bekannte "boiling curve" für Wasser, in der die in den Wasserkörper übertragene Wärmemenge gegen ΔT aufgetragen ist;
- Fig. 3: zeigt ein erfindungsgemäß mit ZnO-Partikeln beschichtetes Silizium-Substrat.

Ein FIBOR realisiert in an sich bekannter Weise das fortgesetzte Filmsieden einer Flüssigkeit. Speziell für Wasser ist bekannt, dass das Erhitzen des Wasserkörpers von einer seiner Grenzflächen her unterschiedlich verläuft in Abhängigkeit vom Temperaturunterschied ΔT zwischen Wasserkörper und Heizfläche.

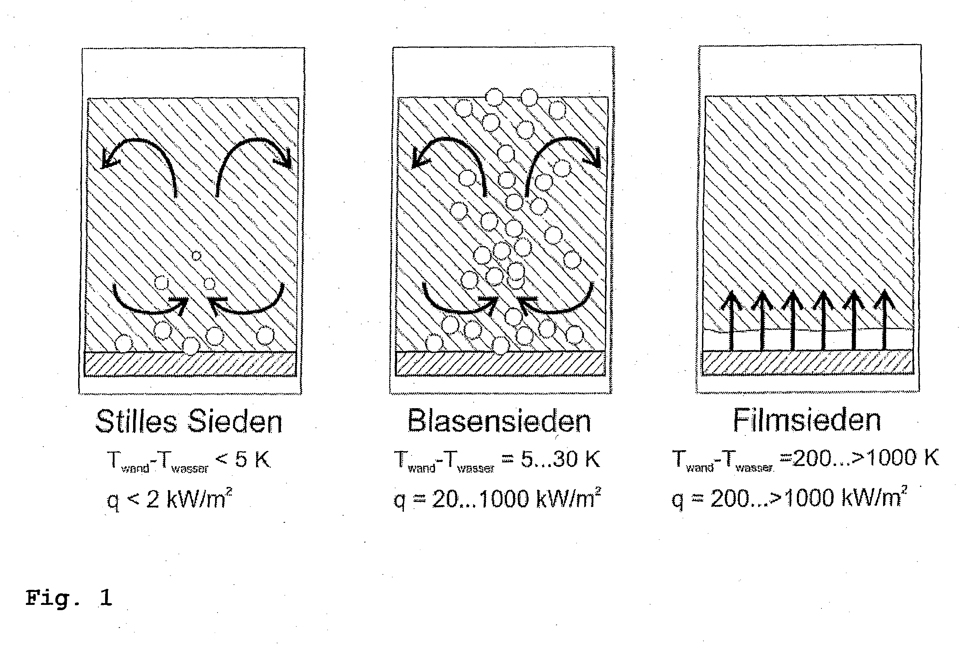

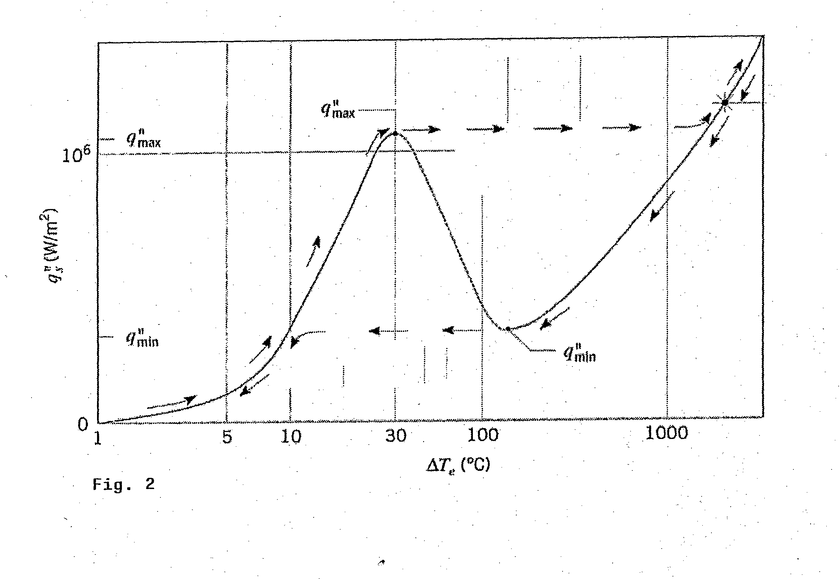

Für ΔT < 5 K erfolgt der Wärmetransport überwiegend konvektiv und unter sporadischer Bildung vereinzelter Wasserdampfblasen an der beheizten Wand, die sich ggf. ablösen, im Wasserkörper aufsteigen und dabei wieder aufgelöst werden (vgl. Fig. 1 linkes Bild). Erhöht man ΔT weiter auf Werte bis zu 30 K, findet nach und nach verstärkte Blasenbildung statt, wobei diese großflächig gebildet werden, sich in rascher Folge ablösen und bis zur Wasseroberfläche aufsteigen (vgl. Fig. 1 mittleres Bild). Aus Fig. 2 ist zu entnehmen, dass die in den Wasserkörper abgeführte Wärmemenge vom Beginn der verstärkten Blasenbildung an bis zum Erreichen von ΔT = 30 K besonders stark zunimmt.

In der Tat sind gewöhnliche Haushaltsherde aus diesem Grund so eingerichtet, dass die Herdplatten absolute Temperaturen um 130 °C erreichen.

Fig. 2 zeigt ebenfalls den Befund, dass die Wärmeübertragung in den Wasserkörper für noch höhere ΔT wieder abnimmt und bei ungefähr ΔT = 200 K ein Minimum erreicht. Der Grund liegt in der verstärkten Verdampfung in unmittelbarer Umgebung der beheizenden Wand. Der Dampf kann nicht mehr schnell genug vom Wasserkörper aufgenommen und abgeführt werden, so dass sich ein isolierendes Dampfpolster zwischen Wasser und Wand über immer größere Flächen ausbildet. Hierin liegt die Analogie zum bekannten Leidenfrost-Effekt. Die minimale Wärmeübertragung tritt offenbar ein, wenn die gesamte Heizfläche von einem Dampffilm bedeckt ist, was den konvektiven Wärmetransport weitgehend unterbindet. Dieser Zustand markiert das Einsetzen des Filmsiedens (vgl. Fig. 1 rechtes Bild). Ein FIBOR hat die Aufgabe, das Filmsieden herbeizuführen und durch geeignete Regelung - etwa der Heiztemperatur - aufrecht zu erhalten.

Die genaue Ausgestaltung des FIBOR liegt im Rahmen des fachmännischen Handelns. Es soll jedoch betont werden, dass ein für den Zweck der Erfindung vorteilhaft ausgebildeter FIBOR den freien Zugang zur Oberfläche des Wasserkörpers gestatten sollte, um die erfindungsgemäße Tauchbeschichtung von Substraten mit Nanopartikeln vorzunehmen. Von daher erscheint ein FIBOR, der als offener Trog mit einer von der Unterseite her wirkenden Heizeinrichtung ausgestaltet ist, besonders geeignet zur Realisierung der Erfindung.

Es sollen folgende allgemeine Vorteile der Erfindung hervorgehoben werden:
1. Das erfindungsgemäße Verfahren benötigt keine definierten Atmosphärenbedingungen, und insbesondere ist kein Überdruck erforderlich. Es kann bei Raumluft in jedem Labor durchgeführt werden.
2. Dem FIBOR müssen lediglich Energie (Wärme) und eine wässrige Metallsalzlösung zugeführt werden, die sich schnell und kurzfristig herstellen lässt. Katalysatoren sind nicht zwingend erforderlich, und es entstehen im Prinzip keine gefährlichen Nebenprodukte.
3. Die Erzeugung der Nanopartikel aus der wässrigen Lösung, das Auftreiben der Nanopartikel auf die Wasseroberfläche und das Überziehen eines Substrats durch Eintauchen in die Lösung erfordern insgesamt nur einige Minuten. Das Verfahren ist damit um ein Vielfaches schneller als andere nasschemische Verfahren, in denen Partikelwachstum stattfindet.

Die einfachste, jederzeit zu realisierende Ausgestaltung eines geeigneten FIBOR ist ein schlichtes Becherglas auf einer Heizplatte. Ein solcher "Becherglas-Reaktor" wird ohne weitere Maßnahmen nicht in der Lage sein, eine kontinuierliche Produktion von Nanopartikeln aufrecht zu erhalten. Diese zusätzlichen Maßnahmen werden aber, wie oben gesagt, als fachmännisch realisierbar erachtet.

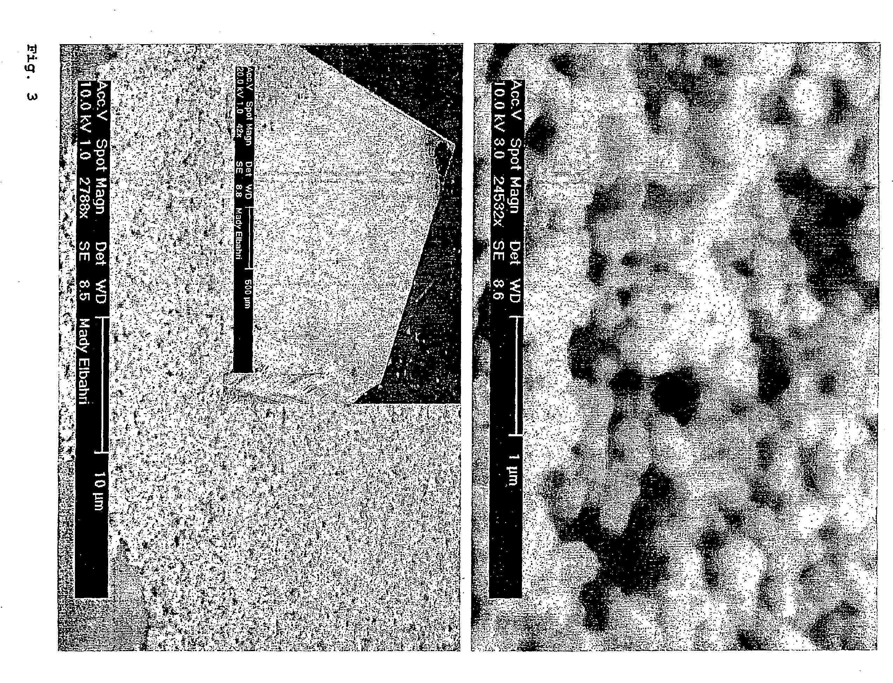

Fig. 3 zeigt Elektronenmikroskop-Aufnahmen eines erfindungsgemäß hergestellten Films aus Zinkoxid-Nanopartikeln auf einem Silizium-Substrat in zwei Vergrößerungen. Zur Herstellung des Films wurde zunächst eine Labor-Heizplatte auf 250-270 °C vorgeheizt. Ein 100 ml Becherglas mit wässriger Zinkacetat-Lösung wurde auf die vorgeheizte Platte gestellt. Messungen belegen, dass die Temperatur der Glasunterseite nach 1-2 Minuten der der Heizplatte entsprach.

Nach etwa 10-15 Minuten bildete sich ein auf der Wasseroberfläche schwimmender Film, und ein Silizium-Substrat wurde langsam und gleichmäßig - über den Zeitraum von etwa einer Minute - in die Lösung getaucht und wieder herausgezogen. Das zuvor schwimmende Filmmaterial blieb an dem Substrat während der Tauchbewegung haften.

Die Aufnahmen aus Fig. 3 beweisen, dass es sich um relativ gleichmäßig verteilte, etwa gleich große Nanopartikel handelt. Ihre Zusammensetzung wurde mittels energiedispersiver Röntgenanalytik (EDX) und Röntgendiffraktometrie (X-Ray-Diffraktion, XRD) als ZnO-Partikel bestätigt.

Wenn man nach einigen Minuten den Tauchvorgang mit einem zweiten Silizium-Substrat wiederholt, bildet sich ein Nanopartikelfilm, dessen Partikelgrößenverteilung weiter streut als der des Films auf dem ersten Substrat. Der Grund dafür liegt zum einen in der Agglomeration der bereits vorhandenen Nanopartikel und zum anderen in der Anlagerung weiterer Ionen aus der Lösung an diese Partikel, d.h. das Partikelwachstum schreitet mit der Zeit voran. Dieser Sachverhalt ist bei der Umsetzung des Verfahrens in einem kontinuierlich laufenden FIBOR zu berücksichtigen.

Da das Substrat durch das Eintauchen in Wasser unter Atmosphärendruck mit dem Partikelfilm überzogen wird, ist die Temperatur, dem das Substrat ausgesetzt wird, praktisch auf etwa 100 °C nach oben beschränkt. Von daher können sowohl vorstrukturierte als auch manche organische Substrate zur Beschichtung vorgesehen werden, sofern nur die erzeugten Partikel an diesen haften. Von besonderem Interesse sind hier Substrate aus kommerziell gängigen, chemisch inerten Polymeren wie etwa Polymethymethacrylat (PMMA) oder irgendein Fluoropolymer (z.B. Teflon ®). Die Haftung der Nanopartikel kann dabei durch eine kontrollierte, temperaturbedingte Aufweichung der Polymere durchaus begünstigt werden.

Das Beispiel Zinkoxid soll hier in Analogie zur DE 10 2005 060 407 A1 nicht einschränkend verstanden werden. Die Forschung in diesem Feld steht noch am Anfang, doch ist schon heute klar, dass sich auch andere Partikel, insbesondere Metalloxid-Partikel, auf die gleiche Weise erzeugen lassen. Von kommerzieller Bedeutung ist insbesondere auch Titandioxid (z.B. als UV-Absorber).

Der Sauerstoff zur Bildung der Oxid-Partikel wird dabei möglicherweise durch thermische Dissoziation von Wassermolekülen bereitgestellt. Es ist aber auch denkbar (und bislang nicht geklärt), dass der in der Lösung gelöste Sauerstoff für die Reaktion eine Rolle spielt. Sollte sich dies bestätigen, wäre beim Aufbau eines kontinuierlichen FIBOR die Überwachung und ggf. Regelung der gelösten Sauerstoffkonzentration in Erwägung zu ziehen. Dies kann durch eine einfache Gaspumpe realisiert werden, die z.B. Raumluft ansaugt und über ein Rohr in das Reaktorgefäß möglichst in die Nähe der reaktiven Wasser/Wasserdampf-Phasengrenze leitet. Alternativ kann man auch reinen Sauerstoff aus Flaschen einleiten.

Abschließend sei darauf hingewiesen, dass das Filmsieden ein an sich fest stehender Begriff ist, der mit dem Minimum der Wärmeübertragung in das Fluid als Startpunkt verbunden ist. Bei der vorliegenden Erfindung soll der Begriff Filmsieden sich aber auch auf den Fall eines ggf. (noch) nicht zusammenhängenden Dampffilmes (üblicherweise als "transition boiling" bezeichnet) beziehen, soweit dieser bereits zur Produktion von Nanopartikeln in der Lage ist. Im Lichte der DE 10 2005 060 407 A1 ist davon auszugehen, dass die Nanopartikel bereits ab einer Wandtemperatur ober-halb von 200 °C entstehen können, wo das klassische Filmsieden noch nicht unbedingt eingesetzt haben muss. Von daher ist Filmsieden im Erfindungssinne hier weiter gefasst zu verstehen.

## Patentansprüche

1. Verfahren zum Beschichten eines Substrats mit oxidischen Nanopartikeln, mit dem Schritt:
- Bereitstellen einer wässrigen Lösung, die Ionen eines Oxidpartikel bildenden Materials enthält,
**gekennzeichnet durch** die weiteren Schritte:
- Filmsieden der Lösung bei Temperaturen oberhalb von 200 °C,
- Eintauchen des Substrats in die wässrige Lösung, so dass die zu beschichtenden Flächen des Substrats die zur Oberfläche der Lösung aufgeschwommenen Nanopartikel durchqueren, und
- Herausziehen des beschichteten Substrats.

2. Verfahren nach Anspruch 1, **dadurch gekennzeichnet, dass** das Substrat mit im wesentlichen konstanter Geschwindigkeit in die Lösung getaucht und wieder herausgezogen wird.

3. Verfahren nach einem der vorangehenden Ansprüche, **dadurch gekennzeichnet, dass** als Oxidpartikel bildendes Material ein Metall gewählt wird.

4. Verfahren nach Anspruch 3, **dadurch gekennzeichnet, dass** das Oxidpartikel bildende Material aus den Elementen Zink oder Titan gewählt wird.

5. Verfahren nach einem der Ansprüche 1 oder 2, **dadurch gekennzeichnet, dass** ein wenigstens ein organisches Material enthaltendes Substrat verwendet wird.

6. Verfahren nach Anspruch 5, **dadurch gekennzeichnet, dass** das organische Material Polymethylmethacrylat (PMMA) oder ein Fluoropolymer ist.

7. Verfahren nach einem der vorangehenden Ansprüche, **dadurch gekennzeichnet, dass** der wässrigen Lösung mit Ionen des Oxidpartikel bildenden Materials Sauerstoff oder Raumluft in regelbarer Menge im Bereich des Dampffilms zugeführt wird.

## Claims

1. A method for coating a substrate with oxidic nanoparticles, with the step of:
- providing an aqueous solution containing ions of a material that forms oxide particles,
**characterised by** the further steps of:
- film boiling the solution at temperatures above 200°C,
- immersing the substrate in the aqueous solution so that the areas of the substrate to be coated pass through the nanoparticles that have risen to the surface of the solution, and
- withdrawing the coated substrate.

2. The method according to claim 1, **characterised in that** the substrate is immersed in the solution and withdrawn again at a substantially constant rate.

3. The method according to one of the preceding claims, **characterised in that** a metal is selected as the material that forms oxide particles.

4. The method according to claim 3, **characterised in that** the material that forms oxide particles is selected from the elements zinc or titanium.

5. The method according to one of claims 1 or 2, **characterised in that** a substrate containing at least one organic material is used.

6. The method according to claim 5, **characterised in that** the organic material is polymethyl methacrylate (PMMA) or a fluoropolymer.

7. The method according to one of the preceding claims, **characterised in that** oxygen or ambient air is fed in a controllable quantity in the area of the steam film into the aqueous solution with ions of the material that forms oxide particles.

## Revendications

1. Procédé pour enduire un substrat avec des nanoparticules oxydées, comprenant l'étape de :
- préparation d'une solution aqueuse contenant des ions d'un matériau formant des particules d'oxyde,
**caractérisé par** les étapes supplémentaires suivantes :
- ébullition en film de la solution à des températures supérieures à 200 °C,
- immersion du substrat dans la solution aqueuse de telle sorte que les surfaces à enduire du substrat traversent les nanoparticules remontées à la surface de la solution, et
- sortie du substrat enduit.

2. Procédé selon la revendication 1, **caractérisé en ce que** le substrat est immergé dans la solution et ressorti avec une vitesse sensiblement constante.

3. Procédé selon l'une des revendications précédentes, **caractérisé en ce qu**'un métal est choisi comme matériau formant des particules d'oxyde.

4. Procédé selon la revendication 3, **caractérisé en ce que** le matériau formant des particules d'oxyde est choisi parmi les éléments zinc ou titane.

5. Procédé selon la revendication 1 ou 2, **caractérisé en ce qu**'un substrat comprenant au moins un matériau organique est utilisé

6. Procédé selon la revendication 5, **caractérisé en ce que** le matériau organique est du polyméthacrylate de méthyle (PMMA) ou un polymère fluoré.

7. Procédé selon l'une des revendications précédentes, **caractérisé en ce que** des ions du matériau formant des particules d'oxyde, de l'oxygène ou de l'air ambiant sont ajoutés en quantité réglable à la solution aqueuse dans la zone du film de vapeur.
